# EUROPEAN PATENT APPLICATION

(11) **EP 4 542 623 A1**
(43) Date of publication of application: **23.04.2025**
(21) Application number: 23823641.8
(22) Date of filing: 24.05.2023
(51) Int. Cl.: H01L 21/205, C30B 25/20, C30B 29/06, H01L 21/20, H01L 21/322, H01L 21/324

(54) **SEMICONDUCTOR WAFER MANUFACTURING METHOD AND SEMICONDUCTOR WAFER**

(30) Priority: 17.06.2022 JP 2022097941
(71) Applicant: Shin-Etsu Handotai Co., Ltd., Tokyo 100-0004 (JP)
(72) Inventor: SUZUKI, Atsushi, Nishishirakawa-gun, Fukushima 961-8061 (JP)
(74) Representative: Sonnenhauser, Thomas Martin
(86) International application number: PCT/JP2023/019323
(87) International publication number: WO 2023/243342

(57) **Abstract**

The present invention is method for producing a semiconductor wafer, the method including steps of: (1) forming a carbon-doped silicon film on a silicon substrate at a first temperature; (2) forming a carbon-undoped silicon film on the carbon-doped silicon film at the first temperature to obtain a stacked wafer; and (3) annealing the stacked wafer at a second temperature higher than the first temperature or further forming a film on the stacked wafer at the second temperature to obtain a semiconductor wafer. This provides a method for producing a semiconductor wafer having a carbon-containing silicon layer without precipitation of SiC on the wafer surface and with inhibited other defects.

## Description

### TECHNICAL FIELD

The present invention relates to a method for producing a semiconductor wafer having a carbon-containing silicon layer.

### BACKGROUND ART

In carbon (C)-doped silicon (Si), properties such as metal-gettering ability and an oxygen-trapping effect, which have not been observed in non-doped Si, are observed. Application for various devices is expected with the above properties, but the C-doped Si at a high concentration has a problem of precipitating SiC on a surface layer due to a thermal treatment. The application for devices requires thermal stability in many steps, for example, film formation at high temperature is required for annealing or stacking with a Si layer, and therefore the thermally unstable properties of the C-doped Si has been problematic.

For film-forming a conventional carbon-containing silicon layer when an epitaxial layer is stacking-formed on a substrate, proposed is an epitaxial-film stacking formation method including: forming a carbon-containing layer at a target carbon concentration of 200 ppm to 5 atom% at 700°C or lower; then forming a cap layer containing no carbon at 700°C or lower; and then performing etching with an etching gas (Patent Document 1). However, there has been no discussion about increase in cost due to increase in a number of the steps by the required additional step being the etching and about an effect on film quality such as defects.

### CITATION LIST

### PATENT LITERATURE

Patent Document 1: JP 5090451 B

### SUMMARY OF INVENTION

### TECHNICAL PROBLEM

The present invention has been made in view of the above circumstances. An object of the present invention is to provide a method for producing a semiconductor wafer having a carbon-containing silicon layer without precipitation of SiC on the wafer surface and with inhibited other defects.

### SOLUTION TO PROBLEM

To solvent the above problem, the present invention provides a method for producing a semiconductor wafer, the method including steps of:
(1) forming a carbon-doped silicon film on a silicon substrate at a first temperature;
(2) forming a carbon-undoped silicon film on the carbon-doped silicon film at the first temperature to obtain a stacked wafer; and
(3) annealing the stacked wafer at a second temperature higher than the first temperature or further forming a film on the stacked wafer at the second temperature to obtain a semiconductor wafer.

By the above method of forming the carbon-undoped silicon film at the first temperature, the semiconductor wafer having a carbon-containing silicon layer without precipitation of SiC on the surface and with inhibited other defects can be produced.

The first temperature is preferably 400°C to 1000°C.

In this case, the first temperature is more preferably 600°C to 800°C.

The carbon-doped silicon film and the carbon-undoped silicon film are desirably formed at the above temperature.

The carbon-undoped silicon film preferably has a film thickness of 5 nm to 200 nm.

In this case, the carbon-undoped silicon film more preferably has a film thickness of 5 nm to 50 nm.

The carbon-undoped silicon film having the above thickness can more certainly exhibit the effect of the present invention.

The carbon-doped silicon film preferably has a carbon atom concentration of 1.0E+17 atoms/cm³ or more and 4.5E+22 atoms/cm³ or less.

In this case, the carbon-doped silicon film more preferably has a carbon atom concentration of 1.0E+18 atoms/cm³ or more and 2.0E+22 atoms/cm³ or less.

In this case, the carbon-doped silicon film further preferably has a carbon atom concentration of 1.0E+19 atoms/cm³ or more and 5.0E+21 atoms/cm³ or less.

The carbon-doped silicon film having a carbon atom concentration within the above range is practically preferable.

In addition, the present invention provides a semiconductor wafer at least including:
a silicon substrate having an upper surface and a lower surface;
a carbon-doped silicon film formed on the upper surface of the silicon substrate; and
a carbon-undoped silicon film formed on the carbon-doped silicon film, wherein
the semiconductor wafer contains no precipitated SiC on a surface on an opposite side of the lower surface of the silicon substrate.

The method for producing a semiconductor wafer of the present invention can yield the semiconductor wafer having the carbon-containing silicon layer without deterioration due to heat and having good film quality of the carbon-undoped silicon film on the surface.

The carbon-undoped silicon film preferably has a film thickness of 5 nm to 200 nm.

In this case, the carbon-undoped silicon film more preferably has a film thickness of 5 nm to 50 nm.

The carbon-undoped silicon film having the above thickness can more certainly exhibit the effect of the present invention.

The carbon-doped silicon film preferably has a carbon atom concentration of 1.0E+17 atoms/cm³ or more and 4.5E+22 atoms/cm³ or less.

In this case, the carbon-doped silicon film more preferably has a carbon atom concentration of 1.0E+18 atoms/cm³ or more and 2.0E+22 atoms/cm³ or less.

In this case, the carbon-doped silicon film further preferably has a carbon atom concentration of 1.0E+19 atoms/cm³ or more and 5.0E+21 atoms/cm³ or less.

The carbon-doped silicon film having a carbon atom concentration within the above range is practically preferable.

### ADVANTAGEOUS EFFECTS OF INVENTION

According to the present invention, forming the carbon-doped silicon film and then forming the carbon-undoped silicon film on the carbon-doped silicon film at the same temperature prevent thermal deterioration of the carbon-doped silicon film due to the subsequent thermal treatment at high temperature to produce the semiconductor wafer having the good-quality carbon-doped silicon layer and having good film quality of the carbon-undoped silicon film on the surface.

### BRIEF DESCRIPTION OF DRAWINGS

FIG. 1 is a flow diagram that describes an example of a first aspect of the method for producing a semiconductor wafer of the present invention;
FIG. 2 is a flow diagram that describes an example of a second aspect of the method for producing a semiconductor wafer of the present invention; and
FIG. 3 is a flowchart in film-forming a semiconductor wafer in Example and Comparative Example.

### DESCRIPTION OF EMBODIMENTS

As noted above, there has been a demand for development of the method for producing the semiconductor wafer having a carbon-containing silicon layer while preventing deterioration due to heat.

The present inventors have earnestly studied the above problem, and consequently found that, in an epitaxial wafer having a gettering effect, defects on the epitaxial layer surface derived from a carbon-doped epitaxial layer can be reduced by forming a doped silicon epitaxial layer so that the carbon concentration is 1.0E+17 atoms/cm³ or more and 4.5E+22 atoms/cm³ or less and forming a carbon-undoped silicon epitaxial layer thereon at both 700°C and a pressure of 1 to 80 Torr, and then forming a silicon epitaxial layer to be a device-active layer at 1080°C. This finding has led to completion of the present invention.

Specifically, the present invention is a method for producing a semiconductor wafer, the method including steps of: (1) forming a carbon-doped silicon film on a silicon substrate at a first temperature; (2) forming a carbon-undoped silicon film on the carbon-doped silicon film at the first temperature to obtain a stacked wafer; and (3) annealing the stacked wafer at a second temperature higher than the first temperature or further forming a film on the stacked wafer at the second temperature to obtain a semiconductor wafer.

Hereinafter, the present invention will be described in detail, but the present invention is not limited thereto.

### [Method for Producing Semiconductor Wafer]

The method for producing a semiconductor wafer of the present invention includes a first aspect and a second aspect. In the first aspect, the carbon-doped silicon film is formed on the silicon substrate and the carbon-undoped silicon film is formed thereon at the first temperature in the step (1) and the step (2) to obtain the stacked wafer, and then a film is further formed on the stacked wafer at a second temperature higher than the first temperature in the step (3). In the second aspect, the stacked wafer is obtained in the step (1) and the step (2) in the same manner as in the first aspect, and then the stacked wafer is annealed at a second temperature higher than the first temperature in the step (3). Hereinafter, each aspect will be described in detail with reference to the drawings.

### [First Aspect]

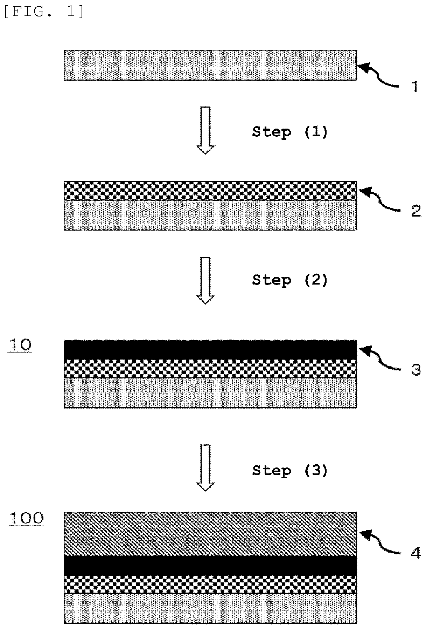

FIG. 1 is a flow diagram that describes an example of the first aspect of the method for producing a semiconductor wafer of the present invention. In the first aspect, the semiconductor wafer is obtained by performing the following steps (1) to (3). Hereinafter, the first aspect will be described with FIG. 1.

### <Step (1)>

As shown in FIG. 1, the step (1) is a step of forming a carbon-doped silicon film 2 on a silicon substrate 1 at the first temperature.

The silicon substrate 1 is not particularly limited, but preferably a single-crystal silicon substrate. The single-crystal silicon substrate is also not particularly limited, and may be a CZ substrate or a FZ substrate. The silicon substrate 1 may be undoped or doped. When doped, the silicon substrate 1 may be n-type or p-type. In the case of n-type, the silicon substrate 1 may be doped with P, Sb, or As, for example. In the case of p-type, the silicon substrate 1 may be doped with B, Al, or Ga, for example. In addition, orientation, diameter, resistivity, etc. of the substrate are also not particularly limited.

On the above silicon substrate 1, the carbon-doped silicon film (silicon epitaxial layer) 2 is formed at the first temperature by, for example, CVD, preferably RP-CVD (reduced-pressure CVD). As for a raw material gas used in this time, for example, monomethylsilane or trimethylsilane is used as a carbon source, and dichlorosilane or monosilane is used as a silicon source. However, the raw material gas is not limited thereto. A film-forming temperature in this time is "the first temperature", and may be, for example, 400 to 1000°C, and preferably 600 to 800°C. The first temperature is not limited thereto. A carbon atom concentration for doping the silicon layer may be regulated by a flow rate of the raw material gas and the film-forming temperature. A pressure in CVD may be 1 to 80 Torr (133 to 10640 Pa).

The carbon atom concentration of the carbon-doped silicon film 2 is preferably 1.0E+17 atoms/cm³ or more and 4.5E+22 atoms/cm³ or less, more preferably 1.0E+18 atoms/cm³ or more and 2.0E+22 atoms/cm³ or less, and further preferably 1.0E+19 atoms/cm³ or more and 5.0E+21 atoms/cm³ or less. The carbon atom concentration may be confirmed by SIMS (Secondary Ion Mass Spectroscopy).

A thickness of the carbon-doped silicon film 2 is not particularly limited, and may be, for example, 10 to 1000 nm, preferably 20 to 500 nm, and more preferably 30 to 200 nm.

### <Step (2)>

As shown in FIG. 1, the step (2) is a step of forming a carbon-undoped silicon film 3 on the carbon-doped silicon film 2 at the first temperature to obtain a stacked wafer 10.

The carbon-undoped silicon film (silicon epitaxial layer) 3 can also be formed by, for example, CVD, preferably RP-CVD (reduced-pressure CVD). As for a raw material gas used in this time, dichlorosilane or monosilane is used, for example. However, the raw material gas is not limited thereto. A pressure in CVD may be 1 to 80 Torr. Note that the carbon-undoped silicon film 3 is formed at a temperature same as the aforementioned film-forming temperature for the carbon-doped silicon film 2 (namely, the first temperature).

The step (1) and the step (2) may be performed in the identical CVD apparatus, or may be performed in different CVD apparatuses.

The carbon-undoped silicon film formed at the first temperature functions as a Si-Cap layer, and can inhibit diffusion of carbon from the carbon-doped silicon film 2 toward an upper layer due to high temperature in further forming a film in the step (3), described later, at a second temperature higher than the first temperature.

A thickness of the carbon-undoped silicon film 3 may be, for example, 5 nm to 200 nm, and preferably 5 nm to 50 nm. Such a film thickness can more certainly inhibit diffusion of carbon from the carbon-doped silicon film 2 toward the semiconductor wafer surface.

### <Step (3)>

As shown in FIG. 1, the step (3) is a step of further forming a film on the stacked wafer 10 at a second temperature higher than the first temperature to obtain a semiconductor wafer 100. FIG. 1 shows an example of further film-forming a silicon film 4 to be a device-active layer on the stacked wafer 10, but the layer to be further film-formed in this step is not limited thereto.

The silicon film (silicon epitaxial layer) 4 to be a device-active layer can also be formed by, for example, CVD, preferably RP-CVD (reduced-pressure CVD). As for a raw material gas used in this time, dichlorosilane or monosilane is used, for example. However, the raw material gas is not limited thereto. A pressure in CVD may be 1 to 80 Torr. Note that the film formation in this step is performed at the second temperature higher than the first temperature.

The second temperature is not particularly limited as long as the temperature is higher than the first temperature, and may be, for example, 800°C or higher, and preferably 1000 to 1200°C.

A thickness of the silicon film 4 to be a device-active layer further film-formed in this step is not particularly limited, and may be set to an appropriate film thickness according to the usage.

The step (3) may be performed in the CVD apparatus identical to that in the step (2), or may be performed in a CVD apparatus different therefrom.

In the present invention, the film is formed at high temperature (the second temperature) in the step (3) not directly on the carbon-doped silicon film 2 but on the carbon-undoped silicon film (Si-Cap layer) 3 formed thereon at low temperature (the first temperature). This procedure can inhibit diffusion of carbon from the carbon-doped silicon film 2 toward the upper layer. Therefore, the semiconductor wafer 100 produced in the present invention contains no carbon diffused toward the silicon film 4 to be a device-active layer, namely no precipitation of SiC on the surface of the epitaxial layer.

### [Second Aspect]

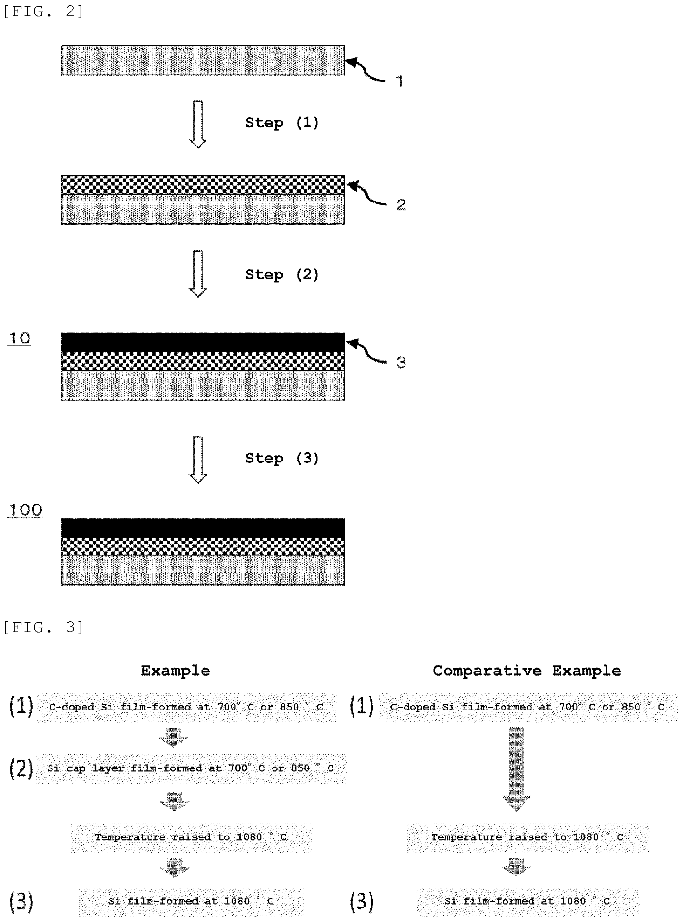

FIG. 2 is a flow diagram that describes an example of the second aspect of the method for producing a semiconductor wafer of the present invention. In the second aspect of the method for producing a semiconductor wafer of the present invention, the semiconductor wafer is obtained by performing the following steps (1) to (3). Hereinafter, the second aspect will be described with FIG. 2.

### <Step (1)>

As shown in FIG. 2, the step (1) is a step of forming a carbon-doped silicon film 2 on a silicon substrate 1 at a first temperature. The step (1) is as described in the aforementioned first aspect.

### <Step (2)>

As shown in FIG. 2, the step (2) is a step of forming a carbon-undoped silicon film 3 on the carbon-doped silicon film 2 at the first temperature to obtain a stacked wafer 10. The step (2) is also as described in the aforementioned first aspect.

### <Step (3)>

As shown in FIG. 2, the step (3) is a step of annealing the stacked wafer 10 at a second temperature higher than the first temperature to obtain a semiconductor wafer 100.

The second temperature in the annealing is not particularly limited as long as the temperature is higher than the first temperature, and may be, for example, 800°C or higher. The second temperature is preferably 1000 to 1200°C.

In the second aspect, the annealing at high temperature (the second temperature) in the step (3) is performed after the carbon-undoped silicon film (Si-Cap layer) 3 is formed at low temperature (the first temperature). Therefore, as in the first aspect, diffusion of carbon from the carbon-doped silicon film 2 toward the upper layer at the high temperature can be inhibited. The semiconductor wafer 100 produced in the second aspect of the present invention also contains no precipitation of SiC on the surface of the epitaxial layer.

### [Semiconductor Wafer]

In addition, the present invention provides a semiconductor wafer at least including: a silicon substrate having an upper surface and a lower surface; a carbon-doped silicon film formed on the upper surface of the silicon substrate; and a carbon-undoped silicon film formed on the carbon-doped silicon film, wherein the semiconductor wafer contains no precipitated SiC on a surface on an opposite side of the lower surface of the silicon substrate.

The semiconductor wafer of the present invention may have further another epitaxial layer, for example, a silicon film to be a device-active layer, formed on the carbon-undoped silicon film.

The semiconductor wafer of the present invention can be produced by the aforementioned method for producing a semiconductor wafer of the present invention. Thus, diffusion of carbon from the carbon-doped silicon film is inhibited by the carbon-undoped silicon film formed thereon, resulting in no precipitation of SiC on the surface of the epitaxial layer.

Therefore, the semiconductor wafer of the present invention has metal-gettering ability, an oxygen-trapping effect, and an effect of improving RF properties, and has the high-quality carbon-undoped silicon film on the surface. Thus, the semiconductor wafer of the present invention can be applied for various devices (RF devices and CIS).

### EXAMPLES

Hereinafter, the present invention will be specifically described by using Examples and Comparative Examples, but the present invention is not limited thereto. In the following Examples and Comparative Examples, defect evaluation of a semiconductor wafer surface is performed by measuring a number of LLS defects using SP3, available from KLA-Tencor Corporation.

In the following Examples 1 to 8, the steps (1) to (3) in the method for producing a semiconductor wafer of the present invention were performed as shown in a flowchart of FIG. 3. Meanwhile, in the following Comparative Examples 1 to 7, only the step (1) and the step (3) in the method for producing a semiconductor wafer of the present invention were performed as shown in the flowchart of FIG. 3, and the step (2) was not performed.

### (Example 1)

A C-doped Si layer (carbon atom concentration: 1.0E+20 atoms/cm³) was grown with 100 nm on a silicon substrate by using RP-CVD under a condition of 700°C and 5 Torr in a mixed-gas atmosphere containing SiH₄ and SiH(CH₃)₃. Then, a C-undoped Si layer (Si-cap layer) was grown with 30 nm at the same 700°C. Thereafter, the temperature was raised to 1080°C, and a Si layer was grown to produce a semiconductor wafer. The number of LLS with 32nm up in this case was 16.

### (Example 2)

A semiconductor wafer was produced as the semiconductor wafer to be evaluated under the same condition of Example 1 except that the thickness of the C-undoped Si layer (Si-cap layer) was 100 nm. The number of LLS with 32nm up in this case was 25.

### (Example 3)

A semiconductor wafer was produced as the semiconductor wafer to be evaluated under the same condition of Example 1 except that the carbon atom concentration was 3.0E+21 atoms/cm³. The number of LLS with 32nm up in this case was 15.

### (Example 4)

A semiconductor wafer was produced as the semiconductor wafer to be evaluated under the same condition of Example 1 except that the carbon atom concentration was 8.0E+21 atoms/cm³. The number of LLS with 32nm up in this case was 165.

### (Example 5)

A semiconductor wafer was produced as the semiconductor wafer to be evaluated under the same condition of Example 1 except that the carbon atom concentration was 2.5E+22 atoms/cm³. The number of LLS with 32nm up in this case was 861.

### (Example 6)

A C-doped Si layer (carbon atom concentration: 2.0E+19 atoms/cm³) was grown with 100 nm on a silicon substrate by using RP-CVD under a condition of 850°C and 5 Torr in a mixed-gas atmosphere containing SiH₄ and SiH₃(CH₃). Then, a C-undoped Si layer (Si-cap layer) was grown with 30 nm at the same 850°C. Thereafter, the temperature was raised to 1080°C, and a Si layer was grown to produce a semiconductor wafer. The number of LLS with 32nm up in this case was 6.

### (Example 7)

A semiconductor wafer was produced as the semiconductor wafer to be evaluated under the same condition of Example 6 except that the carbon atom concentration was 2.0E+18 atoms/cm³. The number of LLS with 32nm up in this case was 26.

### (Example 8)

A semiconductor wafer was produced as the semiconductor wafer to be evaluated under the same condition of Example 6 except that the carbon atom concentration was 4.0E+17 atoms/cm³. The number of LLS with 32nm up in this case was 12.

### (Comparative Example 1)

A C-doped Si layer (carbon atom concentration: 1.0E+20 atoms/cm³) was grown with 100 nm on a silicon substrate by using RP-CVD under a condition of 700°C and 5 Torr in a mixed-gas atmosphere containing SiH₄ and SiH(CH₃)₃. Then, the temperature was raised to 1080°C, and a Si layer was grown to produce a semiconductor wafer. The number of LLS with 32nm up in this case was "overload". Note that "overload" means that the number of LLS is about 30000 or more per wafer.

### (Comparative Example 2)

A semiconductor wafer was produced as the semiconductor wafer to be evaluated under the same condition of Comparative Example 1 except that the carbon atom concentration was 3.0E+21 atoms/cm³. The number of LLS with 32nm up in this case was "overload".

### (Comparative Example 3)

A semiconductor wafer was produced as the semiconductor wafer to be evaluated under the same condition of Comparative Example 1 except that the carbon atom concentration was 8.0E+21 atoms/cm³. The number of LLS with 32nm up in this case was "overload".

### (Comparative Example 4)

A semiconductor wafer was produced as the semiconductor wafer to be evaluated under the same condition of Comparative Example 1 except that the carbon atom concentration was 2.5E+22 atoms/cm³. The number of LLS with 32nm up in this case was "overload".

### (Comparative Example 5)

A C-doped Si layer (carbon atom concentration: 2.0E+19 atoms/cm³) was grown with 100 nm on a silicon substrate by using RP-CVD under a condition of 850°C and 5 Torr in a mixed-gas atmosphere containing SiH₄ and SiH₃(CH₃). Then, the temperature was raised to 1080°C, and a Si layer was grown to produce a semiconductor wafer. The number of LLS with 32nm up in this case was "overload".

### (Comparative Example 6)

A semiconductor wafer was produced as the semiconductor wafer to be evaluated under the same condition of Comparative Example 5 except that the carbon atom concentration was 2.0E+18 atoms/cm³. The number of LLS with 32nm up in this case was "overload".

### (Comparative Example 7)

A semiconductor wafer was produced as the semiconductor wafer to be evaluated under the same condition of Comparative Example 5 except that the carbon atom concentration was 4.0E+17 atoms/cm³. The number of LLS with 32nm up in this case was "overload".

Table 1 summarizes the results of Examples 1 to 8 and Comparative Examples 1 to 7.

**[Table 1]**

| Carbon concentration (atoms/cm³) | 30nm Si cap layer (Examples 1, 3 to 8) | 100nm Si cap layer (Example 2) | Without Si cap layer (Comparative Examples 1 to 7) |
|---|---|---|---|
| 4.0E17 | 12 | - | Overload |
| 2.0E18 | 26 | - | Overload |
| 2.0E19 | 6 | - | Overload |
| 1.0E20 | 16 | 25 | Overload |
| 3.0E21 | 15 | - | Overload |
| 8.0E21 | 165 | - | Overload |
| 2.5E22 | 861 | - | Overload |

As obvious from Table 1, it is found that the semiconductor wafers of Examples 1 to 8 produced by the method for producing a semiconductor wafer of the present invention contain no precipitation of SiC on the surface of the epitaxial layer and extremely few LLS, and diffusion of carbon is inhibited by the Si-Cap layer. Particularly, the case where the carbon concentration in the C-doped Si layer is 3.0E21 atoms/cm³ or less exhibits particularly excellent results. Meanwhile, Comparative Examples 1 to 7, which do not perform the step (2) in the present invention to film-form the device-active layer at high temperature directly on the C-doped Si layer, cause diffusion of carbon from the C-doped Si layer to precipitate SiC on the device-active layer surface, resulting in the considerably large number of LLS (overload).

The present specification encompasses the following invention.

[1]: A method for producing a semiconductor wafer, the method comprising steps of: (1) forming a carbon-doped silicon film on a silicon substrate at a first temperature; (2) forming a carbon-undoped silicon film on the carbon-doped silicon film at the first temperature to obtain a stacked wafer; and (3) annealing the stacked wafer at a second temperature higher than the first temperature or further forming a film on the stacked wafer at the second temperature to obtain a semiconductor wafer.
[2]: The method for producing a semiconductor wafer according to [1], wherein the first temperature is 400°C to 1000°C.
[3]: The method for producing a semiconductor wafer according to [1] or [2], wherein the first temperature is 600°C to 800°C.
[4]: The method for producing a semiconductor wafer according to [1], [2] or [3], wherein the carbon-undoped silicon film has a film thickness of 5 nm to 200 nm.
[5]: The method for producing a semiconductor wafer according to [1], [2], [3] or [4], wherein the carbon-undoped silicon film has a film thickness of 5 nm to 50 nm.
[6]: The method for producing a semiconductor wafer according to [1], [2], [3], [4] or [5], wherein the carbon-doped silicon film has a carbon atom concentration of 1.0E+17 atoms/cm³ or more and 4.5E+22 atoms/cm³ or less.
[7]: The method for producing a semiconductor wafer according to [1], [2], [3], [4], [5] or [6], wherein the carbon-doped silicon film has a carbon atom concentration of 1.0E+18 atoms/cm³ or more and 2.0E+22 atoms/cm³ or less.
[8]: The method for producing a semiconductor wafer according to [1], [2], [3], [4], [5] , [6] or [7], wherein the carbon-doped silicon film has a carbon atom concentration of 1.0E+19 atoms/cm³ or more and 5.0E+21 atoms/cm³ or less.
[9]: A semiconductor wafer, at least comprising:
   a silicon substrate having an upper surface and a lower surface;
   a carbon-doped silicon film formed on the upper surface of the silicon substrate; and
   a carbon-undoped silicon film formed on the carbon-doped silicon film,
   wherein the semiconductor wafer contains no precipitated SiC on a surface on an opposite side of the lower surface of the silicon substrate.
[10]: The semiconductor wafer according to [9], wherein the carbon-undoped silicon film has a film thickness of 5 nm to 200 nm.
[11]: The semiconductor wafer according to [9] or [10], wherein the carbon-undoped silicon film has a film thickness of 5 nm to 50 nm.
[12]: The semiconductor wafer according to [9], [10] or [11], wherein the carbon-doped silicon film has a carbon atom concentration of 1.0E+17 atoms/cm³ or more and 4.5E+22 atoms/cm³ or less.
[13]: The semiconductor wafer according to [9], [10], [11] or [12], wherein the carbon-doped silicon film has a carbon atom concentration of 1.0E+18 atoms/cm³ or more and 2.0E+22 atoms/cm³ or less.
[14]: The semiconductor wafer according to [9], [10], [11], [12] or [13], wherein the carbon-doped silicon film has a carbon atom concentration of 1.0E+19 atoms/cm³ or more and 5.0E+21 atoms/cm³ or less.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A method for producing a semiconductor wafer, the method comprising steps of:
(1) forming a carbon-doped silicon film on a silicon substrate at a first temperature;
(2) forming a carbon-undoped silicon film on the carbon-doped silicon film at the first temperature to obtain a stacked wafer; and
(3) annealing the stacked wafer at a second temperature higher than the first temperature or further forming a film on the stacked wafer at the second temperature to obtain a semiconductor wafer.

2. The method for producing a semiconductor wafer according to claim 1, wherein the first temperature is 400°C to 1000°C.

3. The method for producing a semiconductor wafer according to claim 2, wherein the first temperature is 600°C to 800°C.

4. The method for producing a semiconductor wafer according to claim 1, wherein the carbon-undoped silicon film has a film thickness of 5 nm to 200 nm.

5. The method for producing a semiconductor wafer according to claim 4, wherein the carbon-undoped silicon film has a film thickness of 5 nm to 50 nm.

6. The method for producing a semiconductor wafer according to claim 1, wherein the carbon-doped silicon film has a carbon atom concentration of 1.0E+17 atoms/cm³ or more and 4.5E+22 atoms/cm³ or less.

7. The method for producing a semiconductor wafer according to claim 6, wherein the carbon-doped silicon film has a carbon atom concentration of 1.0E+18 atoms/cm³ or more and 2.0E+22 atoms/cm³ or less.

8. The method for producing a semiconductor wafer according to claim 7, wherein the carbon-doped silicon film has a carbon atom concentration of 1.0E+19 atoms/cm³ or more and 5.0E+21 atoms/cm³ or less.

9. A semiconductor wafer, at least comprising:
a silicon substrate having an upper surface and a lower surface;
a carbon-doped silicon film formed on the upper surface of the silicon substrate; and
a carbon-undoped silicon film formed on the carbon-doped silicon film,
wherein the semiconductor wafer contains no precipitated SiC on a surface on an opposite side of the lower surface of the silicon substrate.

10. The semiconductor wafer according to claim 9, wherein the carbon-undoped silicon film has a film thickness of 5 nm to 200 nm.

11. The semiconductor wafer according to claim 10, wherein the carbon-undoped silicon film has a film thickness of 5 nm to 50 nm.

12. The semiconductor wafer according to claim 9,
wherein the carbon-doped silicon film has a carbon atom concentration of 1.0E+17 atoms/cm³ or more and 4.5E+22 atoms/cm³ or less.

13. The semiconductor wafer according to claim 12,
wherein the carbon-doped silicon film has a carbon atom concentration of 1.0E+18 atoms/cm³ or more and 2.0E+22 atoms/cm³ or less.

14. The semiconductor wafer according to claim 13,
wherein the carbon-doped silicon film has a carbon atom concentration of 1.0E+19 atoms/cm³ or more and 5.0E+21 atoms/cm³ or less.
